# EUROPEAN PATENT SPECIFICATION

(11) **EP 2 065 485 B1**
(45) Date of publication and mention of the grant of the patent: **18.05.2011**
(21) Application number: 07121181.7
(22) Date of filing: 21.11.2007
(51) Int. Cl.: C23C 14/28

(54) **Method and system for continuous or semi-continuous laser deposition.**
Verfahren und System zur kontinuierlichen oder halbkontinuierlichen Laserunterstützen Abscheidung
Procédé et appareillage de déposition utilisant un laser continu et semi-continu

(43) Date of publication of application: 03.06.2009
(73) Proprietor: OTB Solar B.V., 5657 EB Eindhoven (NL)
(72) Inventor: Dings, Franciscus Cornelius, 5657 EB Eindhoven (NL); Brok, Woutherus Johannes Maria, 5657 EB Eindhoven (NL)
(74) Representative: Hatzmann, Martin

(56) References cited:
- US-A- 5 019 552
- US-A- 5 304 281
- US-B1- 6 503 578
- WANG H ET AL: "CdS thin films prepared by continuous wave Nd:YAG laser" PROCEEDINGS OF THE SPIE, SPIE, BELLINGHAM, VA, US, vol. 2531, 1995, pages 201-204, XP009094548 ISSN: 0277-786X

## Description

The invention relates to a method and a system for deposition of material by laser evaporation. The method comprises providing a first laser, said first laser being a continuous or semi-continuous laser, wherein a semi-continuous laser is a pulsed laser having a pulse frequency < 1kHz and a pulse width of at least 0.0001 s; providing a deposition chamber; providing a target of substantially laser evaporative material in said deposition chamber; providing a substrate in said deposition chamber; evacuating said deposition chamber to sub-atmospheric pressure; operating said first laser to direct a first beam of laser light at said target so as to form a cloud of laser evaporated material; rotating said target relative to said first beam of laser light incident on a partial surface area thereof, so as to continuously change the partial surface area of said target being exposed to said first beam of laser light; placing said substrate at least partially within said cloud of laser evaporated material, and depositing said laser evaporated material on said substrate. Such a method is known from for example US 5,304,281 (Wang).

It is an objective of the present invention to provide for an alternative method for laser depositing thin films that allows for a high degree of control over the ablation process.

To this end the invention provides a method according to the above-mentioned type, characterized in that it further comprises scanningly redirecting said first beam of laser light along a direction that is parallel to an axis around which the target is rotated; and translationally moving said substrate, at least partially, through said cloud of laser evaporated material so as to distribute the deposition of said material over a deposition surface of said substrate in order to grow a film of said material on said deposition surface.

A known method of laser deposition, which is often referred to as pulsed laser deposition (PLD), employs a pulsed laser that produces relatively short light pulses having a pulse duration on the order of nanoseconds, picoseconds or even shorter durations. As all or at least the larger part of the energy necessary to ablate the target material is transferred to the target material by means of these relatively short laser pulses, the laser pulses commonly have a relatively high energy content. Consequently, laser ablation at the surface of the target material takes places under rather violent circumstances, including high temperatures and pressures, and steep gradients thereof. The train of intense high power laser pulses striking the target material may cause the decomposition of the molecular structure of a target material, and/or the sublimation of target material (i.e. gasification of material directly from its solid state) whereby particulates, which ideally are not present in a plume of ablated material, are detached from the target. Furthermore, the violent nature of pulsed laser deposition may interfere with an accurate and stable deposition rate. To gain a better control over the ablation process and the composition of the cloud of ablated material, the method according to the invention uses a laser that transfers energy onto the target either continuously or semi-continuously. Such a laser emits its energy at a lower power than the pulsed laser used in the known method described above. It is therefore less likely to decompose the molecular structure of the target material, or to sublimate the target. Through the use of a continuous or semi-continuous laser a so called 'melt' is created at the surface of the target: a local pool of liquid or fluidized target material from which pool said material can be evaporated in a well controlled manner by supplying energy to it. The method according to the invention thus contemplates an ablation process, whereby the target material is first brought into a liquid or fluidized state, from which it is subsequently evaporated. Accurate control over the rate of evaporation of target material from the melt can, for example, be exercised by changing the pulse width and/or pulse frequency of a semi-continuous laser, or changing the wave length of the laser light. The above described method is widely applicable. It can be used to laser deposit any material that can be laser evaporated, such as for instance metals or semi-conductors like silicon.

According to a further aspect of the invention, the method according to the invention further comprises providing a gas atmosphere in said deposition chamber.

By providing a gas atmosphere, elements other than the target material may be incorporated into the deposited material and/or films. Molecules and/or atoms of a so called precursor gas may, for example, react chemically with the laser evaporated material of the target, either before the target material is deposited or at the substrate after deposition.This is even true despite the high growth rates attained by laser induced evaporation deposition. Reactive gases may also be used to eliminate contaminating material from the deposition chamber. For example, a scavenger gas such as silane (SiH4) may be used to effectively eliminate any oxygen (02), which may interfere with the deposition process by oxidizing deposited material. Also non-reactive gases can be useful, for example to reduce the influence of residual gasses (such as water vapour and oxygen) still present in the deposition chamber after evacuation, to facilitate diffusion of the laser evaporated material, and/or to control the dimensions of the cloud of laser evaporated material by changing the pressure of the gas atmosphere inside the deposition chamber.

According to a further elaboration of the invention, said gas atmosphere is a hydrogen gas atmosphere.

A hydrogen gas atmosphere can be particularly useful when the target material to be deposited is to be hydrogenated. Such may for example be the case when amorphous silicon (a-Si) films are produced, in order to reduce the dangling bond density.

According to a further elaboration of the invention, the method according to the invention further comprises providing means for decomposing at least part of the gas comprised by the gas atmosphere into a plasma, and operating said means so as to cause the decomposition of said at least part of the gas into a plasma.

Although an initially non-reactive gas present in the deposition chamber may sometimes be activated through, for example, the temperature of the cloud of laser evaporated material, it may - under circumstances - be necessary or desirable to activate a gas by other means. A plasma - a highly (re)active form of the gas - may be created in many ways, such as through the use of a magnetron, an ICP (inductively coupled plasma)-source, or a pair of electrodes across which a possibly alternating electrical potential difference is applied by means of a controllable power supply. By choosing the background gas and the gas decomposition means appropriately, the kind and the amount of reactive particles present in the deposition chamber can be controlled, and therewith the composition and characteristics of the deposited material. In case the gas decomposition means comprise one or more electrodes, it is relatively easy to ensure that the plasma is present in at least the direct environment of either the target or the substrate. This may, for instance, be achieved by providing the target, respectively the substrate, with a carrier for positioning the element, whereby the carrier also serves as an electrode so as to electrically bias the target or the substrate. By electrically biasing an element, i.e. providing the element with a certain electrical potential relative to its surroundings, particles from a gas or plasma may be attracted towards the element in order to impact on, to be deposited on, or to chemically react with the element. It is noted that, to achieve this effect, it is not necessary that an electrode is physically connected to the element or the substrate or target carrier. It may be sufficient to provide a biased electrode in the vicinity of the element, such as behind it.

According to a further elaboration of the invention, the method according to the invention further comprises providing a second laser, and operating said second laser to direct a second beam of laser light at said target so as to preheat at least a partial surface area of said target.

By means of two lasers the level of control over the evaporation process can be improved.. An auxiliary laser, i.e. the second laser, can be used to preheat the target surface up around for example its melting point or evaporation temperature, whereafter evaporation of the target material can be induced by the first laser. An advantage of this two-step process is that the first laser can be configured to emit its energy at parameters (such as pulse duration, pulse width, pulse height and/or wave length) tailored to the deposition process at hand, and at a relatively low power, thus allowing for very accurate control over the temperature of the target surface. The auxiliary laser may preheat the target surface in several ways, such as by means of line-illumination - through the use of an extra optical element - or by means of a scanning movement of a laser beam over the target surface.

According to a further elaboration of the invention, the method for deposition of material by laser evaporation according to the present invention can be used for manufacturing a thin film solar cell.

The high quality thin films that can be produced using the method according to the invention may be applied in thin film solar cells. The method is fit for the production of both single- as well as multi-layer films of varying thicknesses and surfacial dimensions.

Further elaborations of the invention are described in the claims and in the description of the figures below.

### FIGURES

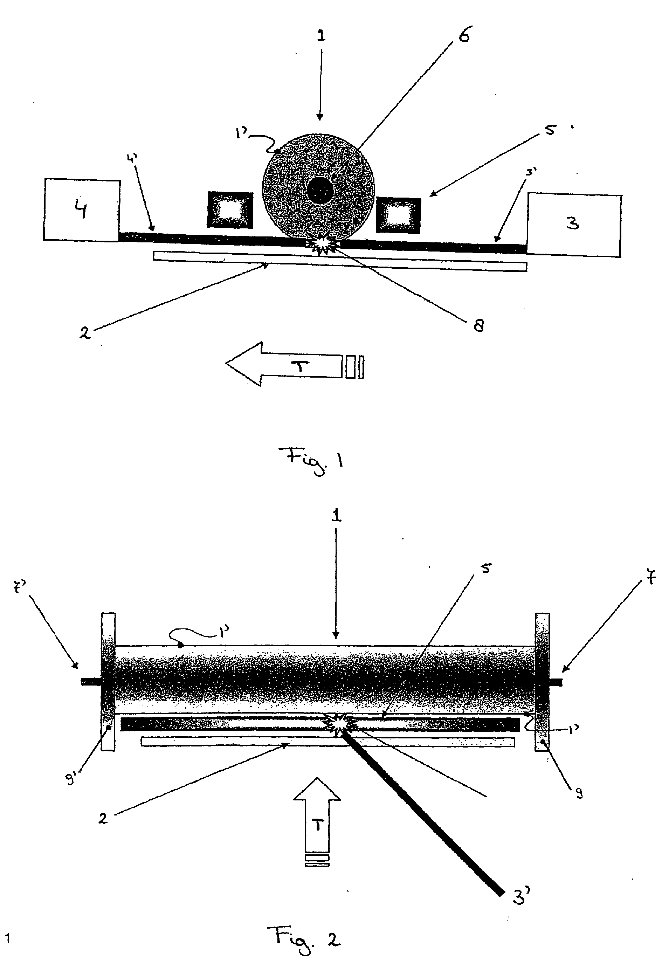

Figures 1 and 2 schematically show a side view, respectively a frontal view, of a system for laser deposition according to the invention.

### DESCRIPTION OF THE FIGURES

Figures 1 and 2 show a system for laser deposition according to the invention. The figures show the following elements: a cylindrical target 1, said target 1 having a target surface 1' which may be provided with an interior fluid channel 6, said fluid channel 6 having end connectors 7 and 7'; a substrate 2 moving in a transport direction T; a first continuous or semi-continuous laser 3 emitting a beam of laser light 3'; a second laser 4 emitting a beam of laser light 4'; a gas or plasma atmosphere 5, a cloud of laser evaporated material 8, and two shields 9, 9'. The aforementioned target 1, substrate 2 and gas or plasma atmosphere 5 are all located inside a deposition chamber (not shown as such), which is evacuated to sub-atmospheric pressure by a pump (not shown). The lasers 3, 4 are not necessarily located inside the deposition chamber; they may also be located outside the deposition chamber, whereby the produced beams of laser light 3', 4' travel through one or more transparent windows into the deposition chamber. A such transparent window may, for example, be made of quartz. Because of the high temperatures to which a such window is exposed in use, it may advantageously possess self-cleaning properties with regard to parasitic deposition.

To evaporate target material off a target 1, two lasers 3, 4 are used. The second laser 4, i.e. the auxiliary laser, is employed to preheat at least a patch of target surface 1' up to a certain temperature, such as a temperature around the melting or evaporation point of the target material. Subsequently, the first laser 3 is employed to accurately induce evaporation of the target material at said patch of target surface 1'. Care is taken to ensure that the target material is controllably evaporated from a melt, i.e. a region of the target surface 1' comprising liquid or fluidized target material. To this end, the first laser operates either continuously or semi-continuously at a pulse frequency < 1 kHz and with a pulse width of at least 0.0001 s. The wave length of the laser is preferably in the range of 0.3 µm - 15 µm, more preferably in the range of 0.8 µm - 12 µm. This combination of parameters ensures a continuous or at least a semi-continuous transfer of energy onto the target, whereby the power at which the energy is transferred is neither too high nor too low, and appropriate for most deposition applications. Based on, for example, the specific target material chosen, the parameters may be optimized within the given ranges. In the case of a silicon target, for instance, a wave length of about 1 µm may be advantageous as silicon tends to absorb energy supplied at or around this wave length relatively well. The first laser 3 and the second laser 4 are operated in cooperation. The produced beams of laser light 3', 4' may thereby perform a complementary scanning movement over the target surface 1', along the longitudinal axis of the cylindrical target 1. Alternatively, the second laser 4 may be used in a non-scanning manner. Through the use of an extra optical element, for example, the second laser 4 may be used to provide a line illumination on the target 1, such that the illuminated surface part of the target is preheated and fluidized, and an elongated melt is created. The first laser 3 may then subsequently scan along said elongated melt provided on the target surface in order to evaporate the preheated target material. It is noted that although this embodiment shows two lasers 3, 4, a different embodiment using only one laser 3 may provide the effect of the invention as well.

To realize uniform evaporation of the target 1, said target 1 is rotated around its longitudinal axis. The length of the target 1 has been made to correspond approximately to the width of the substrate 2, as is clearly shown in figure 2. By moving the substrate 2 along a transport direction T perpendicular to the axis of the target 1, a layer of target material can be deposited onto the whole deposition surface of said substrate 2. An advantage of the setup shown in figures 1 and 2 is that the so called parasitic deposition, i.e. deposition of target material onto places other than the substrate 2, is limited. The distance between the substrate 2 and the target surface 1', and the dimensions of the substrate 2 relative to the dimensions of the cloud of laser evaporated material 8, are chosen such that any evaporated material will quickly come into contact with substrate 2, to which it will adhere. Typically, the distance between the target surface part at which the laser or lasers impact the target and the substrate surface part which is most adjacent to that target surface part is in the range of 0.5 - 5 mm. To further minimize parasitic deposition and contamination of the deposition chamber, shields 9, 9' may be attached to the extremities of the target, so as to confine the cloud of laser evaporated material 8. Advantageously, the shields 9, 9' also contribute to an efficient use of target material, as target material incidentally deposited onto the shields may be reintroduced into the cloud of evaporated material 8 due to the environmental conditions at the surface of the shields.

It is noted that the substrate 2 may be subject to high temperatures, and should therefore be made of heat resistant material, such as glass. High substrate temperatures may, for example, result from contact with the cloud of laser evaporated material 8, the gas or plasma 5, or from direct heating of the substrate by a heating device (not shown). Heating by a heating device may, for example, be advantageous in cases where laser evaporated material does not adhere adequately to a substrate with a too low temperature, or in cases where the thermal motion of the deposited material is necessary to achieve a film with the desired structure. The target 1 may also be subject to high temperatures. To prevent the target 1 from overheating, it may be provided with an interior fluid channel 6, through which a cooling fluid circulates. Alternatively, the interior fluid channel 6 may be used to preheat the target 1 by circulating a heating fluid through it. The substrate and/or the target may be provided with a temperature sensor - possibly at a distance from the substrate and/or target, such as in the case of a pyrometer -, which sensor outputs a sensor signal to a control device that, based on this input, can monitor and control the respective temperature by controlling, for instance, the flow of fluid through the interior fluid channel or the parameters of the first or second laser. Likewise, the deposition chamber may be provided with a pressure sensor.

Although the invention is described above with respect to a certain embodiment, it is understood that one skilled in the art can apply various changes and adaptations without leaving the scope of the present invention as defined by the claims.

## Claims

1. Method for laser deposition comprising:
- providing a first laser (3), said first laser being a continuous or semi-continuous laser, wherein a semi-continuous laser is a pulsed laser having a pulse frequency < 1kHz and a pulse width of at least 0.0001 s;
- providing a deposition chamber;
- providing a substantially cylindrical target (1) of substantially laser evaporative material in said deposition chamber;
- providing a substrate in said deposition chamber (2);
- evacuating said deposition chamber to sub-atmospheric pressure;
- operating said first laser (3) to direct a first beam of laser light (3') at said target (1) so as to form a cloud (8) of laser evaporated material;
- rotating said target (1) relative to said first beam of laser light (3') incident on a partial surface area thereof, so as to continuously change the partial surface area of said target being exposed to said first beam of laser light;
- placing said substrate (2) at least partially within said cloud (8) of laser evaporated material;
- depositing said laser evaporated material on said substrate (2);
**characterized in that** the method further comprises:
- scanningly redirecting said first beam of laser light along a direction that is parallel to a longitudinal axis around which the target is rotated, and
- translationally moving said substrate, at least partially, through said cloud of laser evaporated material so as to distribute the deposition of said material over a deposition surface of said substrate in order to grow a film of said material on said deposition surface.

2. Method according to claim 1, wherein laser light produced by the first laser comprises one or more wave lengths in the range of 0.3 µm - 15 µm, preferably in the range of 0.8 µm - 12 µm.

3. Method according to any of the preceding claims, further comprising
- providing a gas atmosphere in said deposition chamber.

4. Method according to claim 3, wherein the provided gas atmosphere is a hydrogen gas atmosphere.

5. Method according to claim 3 or 4, further comprising
- providing means for decomposing at least part of the gas comprised by the gas atmosphere into a plasma,
- operating said means so as to cause the decomposition of said at least part of the gas into a plasma.

6. Method according to claim 5, wherein said means for decomposing gas into a plasma comprise two electrodes and a controllable power supply connected thereto, and wherein operating said means so as to cause the decomposition of gas comprises applying an appropriate electrical potential difference to the electrodes by means of said power supply.

7. Method according to claim 6, wherein one of said electrodes, or a third electrode connected to said controllable power supply, is configured to serve as a substrate- or a target carrier.

8. Method according to any of the preceding claims, wherein said substantially laser evaporative material of which the target is made, is silicon.

9. Method according to any of the preceding claims, wherein providing said substrate comprises providing a heat resistant substrate, such as a substrate made of glass.

10. Method according to any of the preceding claims, wherein providing a target of laser evaporative material comprises providing a target with an interior fluid channel, and further comprising causing a flow of fluid through said interior fluid channel so as to control the temperature of said target.

11. Method according to any of the preceding claims, further comprising
- providing a heating device for heating said substrate
- heating said substrate by means of said heating device while depositing said laser evaporated material on said substrate.

12. Method according to claim 1, whereby said target is rotated around an axis that extends in a first direction, and whereby said substrate is moved along a second direction that is substantially perpendicular to said first direction.

13. Method according to any of the preceding claims, further comprising
- providing a second laser
- operating said second laser so as to preheat a partial surface area of said target.

14. Method according to claim 13, wherein the first laser and the second laser are operated in cooperation, whereby the second laser is operated to preheat a partial surface area of said target, and whereby the first laser is scanningly directed at said partial surface area so as to evaporate the preheated target material.

15. Use of a method according to any of the preceding claims for manufacturing a thin film solar cell.

16. Apparatus suitable for laser deposition comprising
- a first laser (3), said first laser being a continuous or semi-continuous laser, wherein a semi-continuous laser is a pulsed laser having a pulse frequency < 1 kHz and a pulse width of at least 0.0001 s;
- a deposition chamber, said deposition chamber comprising at least one channel through which matter can be supplied to and/or discharged from the deposition chamber;
- a substantially cylindrical target (1) of substantially laser evaporative material, said target (1) being located in said deposition chamber;
- means for rotating said target around at least one axis;
- a substrate (2), said substrate (2) being located in said deposition chamber, and
- a pump for evacuating the deposition chamber, said pump being connectable to a said channel of the deposition chamber;
**characterized in that**
- said apparatus is configured to make a first laser beam (3') produced by said first laser (3) perform a scanning movement over a surface of said target (1) along a direction that is parallel to the at least one axis around which the target is rotated, said at least one axis being a longitudinal axis of the target, while the apparatus further comprises:
- means configured to translationally move said substrate along at least one direction (T), such that said substrate (2) is movable, at least partially, through a cloud (8) of laser evaporated material so as to distribute the deposition of said material over a deposition surface of said substrate in order to grow a film of said material on said deposition surface.

17. Apparatus according to claim 16, wherein said first laser produces light comprising one or more wave lengths in the range of 0.3 µm - 15 µm, preferably in the range of 0.8 µm - 12 µm.

18. Apparatus according to claim 16 or 17, further comprising a gas supply for providing a gas atmosphere, for example a hydrogen atmosphere, inside the deposition chamber.

19. Apparatus according to claim 18, further comprising means for decomposing the gas comprised by the gas atmosphere into a plasma.

20. Apparatus according to claim 19, wherein said means for decomposing the gas into a plasma comprise two electrodes and a controllable power supply connected thereto.

21. Apparatus according to claim 20, wherein one of said electrodes, or a third electrode connected to said controllable power supply, is configured to serve as a substrate- or a target carrier.

22. Apparatus according to any of the claims 16-21, wherein said laser evaporative material of which the target is made, is silicon.

23. Apparatus according to any of the claims 16-22, wherein said substrate is made of a heat resistant material, such as glass.

24. Apparatus according to any of the claims 16-23, wherein said target of laser evaporative material comprises an interior fluid channel for circulation of a temperature control fluid.

25. Apparatus according to any of the claims 16-24, further comprising a heating device for heating said substrate.

26. Apparatus according to any of the claims 16-25, further comprising a second laser for cooperation with said first laser, wherein said second laser is operated to preheat at least a partial surface area of said target.

27. Apparatus according to any one of the claims 16-26, further comprising at least one sensor for measuring either a temperature of the substrate, a temperature of the target or the pressure in the deposition chamber.

28. Apparatus according to claim 27, further comprising a control device for controlling either the temperature of the substrate, based on informational input from a substrate temperature sensor, the temperature of the target, based on informational input from a target temperature sensor, or the pressure in the deposition chamber, based on informational input from a deposition chamber pressure sensor.

## Patentansprüche

1. Verfahren für eine Laserabscheidung, umfassend
- Bereitstellen eines ersten Lasers (3), wobei der erste Laser ein Dauer- oder teilweise kontinuierlicher Laser ist, wobei ein teilweise kontinuierliche Laser ein gepulster Laser ist, der eine Pulsfrequenz < 1kHz und eine Pulslänge von mindestens 0,0001 s aufweist;
- Bereitstellen einer Abscheidungkammer;
- Bereitstellen eines im Wesentlichen zylindrischen Ziels (1), das im Wesentlichen aus mit einem Laser verdampfbarem Material besteht, in der Abscheidungskammer;
- Bereitstellen eines Substrats in der Abscheidungskammer (2);
- Absaugen der Abscheidungskammer auf subatmosphärischen Druck,
- Betreiben des ersten Lasers (3), um einen ersten Strahl Laserlicht (3') auf das Ziel (1) zu richten, um so eine Wolke (8) von mit dem Laser verdampften Material zu bilden;
- Rotieren des Ziels (1) relativ zu dem ersten Strahl Laserlicht (3'), das auf einen Teiloberflächenbereich davon einfällt, um so den Teiloberflächenbereich des Ziels fortdauernd zu ändern, der dem ersten Strahl Laserlicht ausgesetzt ist;
- Anordnen des Substrats (2) zumindest teilweise in der Wolke (8) des mit einem Laser verdampften Materials;
- Anordnen des mit einem Laser verdampften Materials auf dem Substrat (2), **dadurch gekennzeichnet, dass** das Verfahren weiterhin umfasst:
- Abtastendes Neuausrichten des ersten Strahls Laserlicht entlang einer Richtung, die sich parallel zu einer Längsachse befindet, um die das Ziel rotiert, und
- Translatorisches Bewegen des Substrats, zumindest teilweise durch die Wolke des mit einem Laser verdampften Materials, um so die Abscheidung des Materials über eine Abscheidungsoberfläche des Substrats zu verteilen, um einen Film des Materials auf der Abscheidungsoberfläche wachsen zu lassen.

2. Verfahren nach Anspruch 1, wobei das durch den ersten Laser hergestellte Laserlicht eine oder mehrere Wellenlängen in dem Bereich von 0,3 µm - 15 µm, vorzugsweise in dem Bereich von 0,8 µm - 12 µm, umfasst.

3. Verfahren nach einem der vorstehenden Ansprüche, weiter umfassend
- Bereitstellen einer Gasatmosphäre in der Abscheidungskammer.

4. Verfahren nach Anspruch 3, wobei die bereitgestellte Gasatmosphäre eine Atmosphäre aus Wasserstoffgas ist.

5. Verfahren nach Anspruch 3 oder 4, weiter umfassend
- Bereitstellen von Mitteln zum Abbauen von mindestens einem Teil des Gases, das in der Gasatmosphäre umfasst ist, in ein Plasma,
- Betreiben des Mittels, um so den Abbau von dem zumindest einen Teil des Gases in ein Plasma zu bewirken.

6. Verfahren nach Anspruch 5, wobei das Mittel zum Abbauen von Gas in ein Plasma zwei Elektroden und eine damit verbundene steuerbare Stromversorgung umfasst, und wobei das Betreiben des Mittels um den Abbau des Gases zu bewirken das Anbringen einer geeigneten elektrischen Potentialdifferenz an den Elektroden durch die Stromversorgung umfasst.

7. Verfahren nach Anspruch 6, wobei eine der Elektroden oder eine mit der steuerbaren Stromversorgung verbundene dritte Elektrode so konfiguriert ist, dass sie als ein Substrat- oder Zielträger zu dient.

8. Verfahren nach einem der vorstehenden Ansprüche, wobei das im Wesentlichen mit einem Laser verdampfbare Material, aus dem das Ziel hergestellt ist, Silikon ist.

9. Verfahren nach einem der vorstehenden Ansprüche, wobei ein Bereitstellen des Substrats ein Bereitstellen eines wärmebeständigen Substrats, wie beispielsweise ein aus Glas hergestelltes Substrat, umfasst.

10. Verfahren nach einem der vorstehenden Ansprüche, wobei ein Bereitstellen eines Ziels eines mit einem Laser verdampfbaren Materials ein Bereitstellen eines Ziels mit einem inneren Fluidkanal umfasst, und weiterhin ein Bewirken eines Fluidflusses durch das innere des Fluidkanals umfasst, um so die Temperatur des Ziels zu steuern.

11. Verfahren nach einem der vorstehenden Ansprüche, weiter umfassend
- Bereitstellen einer Heizvorrichtung zum Heizen des Substrats,
- Heizen des Substrats durch die Heizvorrichtung, während das mit einem Laser verdampfbare Material auf dem Substrat abgeschieden wird.

12. Verfahren nach Anspruch 1, wobei das Ziel um eine Achse rotiert wird, die sich in eine erste Richtung erstreckt, und wobei das Substrat entlang einer zweiten Richtung bewegt wird, die im Wesentlichen senkrecht zu der ersten Richtung ist.

13. Verfahren nach einem der vorstehenden Ansprüche, weiter umfassend
- Bereitstellen eines zweiten Lasers,
- Betreiben des zweiten Lasers, um so einen Teiloberflächenbereich des Ziels vorzuheizen.

14. Verfahren nach Anspruch 13, wobei der erste Laser und der zweite Laser in Zusammenarbeit betrieben werden, wobei der zweite Laser betrieben wird, um einen Teiloberflächenbereich des Ziels vorzuwärmen, und wobei der erste Laser zu dem Teiloberflächenbereich abtastend ausgerichtet ist, um so das vorgeheizte Zielmaterial zu verdampfen.

15. Verwendung eines Verfahrens nach einem der vorstehenden Ansprüche zum Herstellen einer Dünnfilmsolarzelle.

16. Vorrichtung, die für eine Laserabscheidung geeignet ist, umfassend
- einen ersten Laser (3), wobei der erste Laser ein Dauer- oder teilweise kontinuierlicher Laser ist, wobei der teilweise kontinuierliche Laser ein gepulster Laser ist, der eine Pulsfrequenz von < 1kHz und eine Pulslänge von mindestens 0,0001 s aufweist;
- eine Abscheidungskammer umfassend mindestens einen Kanal, durch den der Abscheidungskammer Materie zugeführt und/oder von dieser abgegeben bzw. abgelassen werden kann;
- ein im Wesentlichen zylindrisches Ziel (1) von im Wesentlichen aus einem mit einem Laser verdampfbaren Material, wobei sich das Ziel (1) in der Abscheidungskammer befindet;
- Mittel zum Rotieren des Ziels um mindestens eine Achse;
- ein Substrat (2), das sich in der Abscheidungskammer befindet; und
- eine Pumpe zum Absaugen der Abscheidungskammer, wobei die Pumpe mit einem Kanal der Abscheidungskammer verbunden sein kann;
**dadurch gekennzeichnet, dass**
- die Vorrichtung dazu konfiguriert ist, einen ersten Laserstrahl (3') zu erzeugen, der durch den ersten Laser (3) hergestellt wird und der über eine Oberfläche des Ziels (1) entlang einer Richtung eine Abtastbewegung ausführt, die parallel zu der mindestens einen Achse steht, um die das Ziel rotiert wird, wobei die mindestens eine Achse eine Längsachse des Ziels ist, wobei die Vorrichtung weiterhin umfasst
- Mittel, die konfiguriert sind, das Substrat entlang mindestens einer Richtung (T) translatorisch zu bewegen, so dass das Substrat (2) zumindest teilweise durch eine Wolke (8) des mit einem Laser verdampften Materials bewegt werden kann, um so die Abscheidung des Materials über eine Abscheidungsoberfläche des Substrats zu verteilen, um einen Film des Materials auf der Abscheidungsoberfläche wachsen zu lassen.

17. Vorrichtung nach Anspruch 16, worin der erste Laser ein Licht herstellt, das eine oder mehrere Wellenlängen in dem Bereich von 0,3µm - 15 µm, vorzugsweise in dem Bereich von 0,8 µm -12µm, umfasst.

18. Vorrichtung nach Anspruch 16 oder 17, weiter umfassend eine Gasversorgung, um eine Gasatmosphäre, beispielsweise eine Wasserstoffatmosphäre, in der Abscheidungskammer bereitzustellen.

19. Vorrichtung nach Anspruch 18, weiter umfassend Mittel zum Abbauen des Gases, das in der Gasatmosphäre umfasst ist, in ein Plasma.

20. Vorrichtung nach Anspruch 19, worin das Mittel zum Abbauen des Gases in ein Plasma zwei Elektroden und eine damit verbundene steuerbare Stromversorgung umfasst.

21. Vorrichtung nach Anspruch 20, worin eine der Elektroden oder eine mit der steuerbaren Stromversorgung verbundene dritte Elektrode dazu konfiguriert ist, als ein Substrat- oder ein Zielträger zu dienen.

22. Vorrichtung nach einem der Ansprüche 16-21, worin das mit einem Laser verdampfbare Material, aus dem das Ziel hergestellt ist, Silikon ist.

23. Vorrichtung nach einem der Ansprüche 16-22, worin das Substrat aus einem hitzebeständigen Material, wie beispielsweise Glas, hergestellt ist.

24. Vorrichtung nach einem der Ansprüche 16-23, worin das Ziel aus einem mit einem Laser verdampfbaren Material einen inneren Fluidkanal für einen Kreislauf eines Temperatursteuerfluids umfasst.

25. Vorrichtung nach einem der Ansprüche 16-24, weiter umfassend eine Heizvorrichtung zum Heizen des Substrats.

26. Vorrichtung nach einem der Ansprüche 16-25, weiter umfassend einen zweiten Laser zur Zusammenarbeit mit dem ersten Laser, worin der zweite Laser betrieben wird, um zumindest einen Teiloberflächenbereich des Ziels vorzuheizen.

27. Vorrichtung nach einem der Ansprüche 16-26, weiter umfassend mindestens einen Sensor zum Erfassen entweder einer Temperatur des Substrats, einer Temperatur des Ziels oder des Drucks in der Abscheidungskammer.

28. Vorrichtung nach Anspruch 27, weiter umfassend eine Steuervorrichtung, um entweder die Temperatur des Substrats, basierend auf Eingangsinformation von einem Substrattemperatursensor, die Temperatur des Ziels, basierend auf Eingangsinformation von einem Zieltemperatursensor, oder den Druck in der Abscheidungskammer, basierend auf Eingangsinformation von einem Drucksensor der Abscheidungskammer, zu steuern.

## Revendications

1. Procédé de dépôt laser comprenant les étapes
consistant à :
mettre en oeuvre un premier laser (3), ledit premier laser étant un laser continu ou semi-continu, dans lequel un laser semi-continu est un laser pulsé ayant une fréquence d'impulsion < 1 kHz et une largeur d'impulsion d'au moins 0,0001 s ;
mettre en oeuvre une chambre de dépôt ;
- mettre en oeuvre une cible sensiblement cylindrique (1) de matériau s'évaporant sensiblement au laser dans ladite chambre de dépôt ;
mettre en oeuvre un substrat dans ladite chambre de dépôt (2) ;
- évacuer ladite chambre de dépôt à une pression sous-atmosphérique ;
actionner ledit premier laser (3) pour diriger un premier faisceau de lumière laser (3') sur ladite cible (1) afin de former un nuage (8) de matériau évaporé au laser ;
- soumettre ladite cible (1) à une rotation par rapport audit premier faisceau de lumière laser (3') incident sur sa surface spécifique partielle afin de modifier en continu la surface spécifique partielle de ladite cible qui est exposée audit premier faisceau de lumière laser ;
placer ledit substrat (2) au moins en partie à l'intérieur dudit nuage (8) de matériau évaporé sous l'effet du laser ;
déposer ledit matériau évaporé sous l'effet du laser sur ledit substrat (2) ; **caractérisé en ce que** le procédé comprend en outre les étapes consistant à :
rediriger par balayage ledit premier faisceau de lumière laser le long d'une direction qui est parallèle à un axe longitudinal autour duquel la cible est soumise à une rotation, et
- déplacer en translation ledit substrat, au moins en partie, à travers ledit nuage de matériau évaporé sous l'effet du laser afin de distribuer le dépôt dudit matériau sur une surface de dépôt dudit substrat afin de faire croître un film dudit matériau sur ladite surface de dépôt.

2. Procédé selon la revendication 1, dans lequel la lumière laser produite par le premier laser comprend une ou plusieurs longueurs d'onde dans la plage de 0,3 µm à 15 µm, de préférence dans la plage de 0,8 µm à 12 µm.

3. Procédé selon l'une quelconque des revendications précédentes, comprenant en outre l'étape consistant à :
- établir une atmosphère gazeuse dans ladite chambre de dépôt.

4. Procédé selon la revendication 3, dans lequel l'atmosphère gazeuse établie est une atmosphère de gaz hydrogène.

5. Procédé selon la revendication 3 ou 4, comprenant en outre les étapes consistant à :
- fournir des moyens pour décomposer au moins une partie du gaz constitué par l'atmosphère gazeuse en plasma, et
- actionner lesdits moyens pour entraîner la décomposition de ladite au moins une partie du gaz en plasma.

6. Procédé selon la revendication 5, dans lequel lesdits moyens de décomposition du gaz en plasma comprennent deux électrodes et une alimentation en énergie réglable connectée à celles-ci, et dans lequel l'actionnement desdits moyens pour entraîner la décomposition du gaz comprend l'application d'une différence appropriée de potentiel électrique aux électrodes à l'aide de ladite alimentation en énergie.

7. Procédé selon la revendication 6, dans lequel une desdites électrodes, ou une troisième électrode connectée à ladite alimentation en énergie réglable, est configurée pour servir de support de substrat ou de support de cible.

8. Procédé selon l'une quelconque des revendications précédentes, dans lequel ledit matériau s'évaporant sensiblement sous l'effet du laser dans lequel la cible est fabriquée, est du silicium.

9. Procédé selon l'une quelconque des revendications précédentes, dans lequel la fourniture dudit substrat comprend la mise en oeuvre d'un substrat résistant à la chaleur, tel qu'un substrat fabriqué en verre.

10. Procédé selon l'une quelconque des revendications précédentes, dans lequel la fourniture d'une cible de matériau s'évaporant sous l'effet du laser comprend la fourniture d'une cible avec un canal de fluide intérieur, et comprenant en outre l'étape consistant à entraîner un écoulement de fluide à travers ledit canal de fluide intérieur de manière à régler la température de ladite cible.

11. Procédé selon l'une quelconque des revendications précédentes, comprenant en outre les étapes consistant à :
mettre en oeuvre un dispositif de chauffage pour chauffer ledit substrat, et
- chauffer ledit substrat à l'aide dudit dispositif de chauffage tout en déposant ledit matériau évaporé sous l'effet du laser sur ledit substrat.

12. Procédé selon la revendication 1, dans lequel ladite cible est soumise à une rotation autour d'un axe dans une première direction et dans lequel ledit substrat est déplacé le long d'une seconde direction qui est sensiblement perpendiculaire à ladite première direction.

13. Procédé selon l'une quelconque des revendications précédentes, comprenant en outre les étapes consistant à :
- mettre en oeuvre un second laser, et
- actionner ledit second laser afin de préchauffer une surface spécifique partielle de ladite cible.

14. Procédé selon la revendication 13, dans lequel on actionne le premier laser et le second laser en coopération, de sorte que le second laser soit actionné pour préchauffer une surface spécifique partielle de ladite cible et que le premier laser soit dirigé par balayage sur ladite surface spécifique partielle afin d'évaporer le matériau cible préchauffé.

15. Utilisation d'un procédé selon l'une quelconque des revendications précédentes pour fabriquer une pile solaire à couche mince.

16. Appareil convenant à un dépôt laser, comprenant :
- un premier laser (3), ledit premier laser étant un laser continu ou semi-continu, dans lequel un laser semi-continu est un laser pulsé ayant une fréquence d'impulsion < 1 kHz et une largeur d'impulsion d'au moins 0,0001 s ;
- une chambre de dépôt, ladite chambre de dépôt comprenant au moins un canal par lequel on peut acheminer de la matière dans la chambre de dépôt et/ou l'en décharger ;
- une cible sensiblement cylindrique (1) de matériau s'évaporant sensiblement sous l'effet du laser, ladite cible (1) étant placée dans ladite chambre de dépôt ;
- des moyens pour soumettre ladite cible à une rotation autour d'au moins un axe ;
- un substrat (2), ledit substrat (2) étant placé dans ladite chambre de dépôt, et
- une pompe pour évacuer la chambre de dépôt, ladite pompe pouvant être raccordée à un dit canal de la chambre de dépôt ;
**caractérisé en ce que**
- ledit appareil est configuré pour qu'un premier faisceau laser (3') produit par ledit premier laser (3) effectue un mouvement de balayage sur une surface de ladite cible (1) le long d'une direction qui est parallèle au au moins un axe autour duquel la cible est soumise à une rotation, ledit au moins un axe étant un axe longitudinal de la cible, tandis que l'appareil comprend en outre:
- des moyens configurés pour déplacer en translation ledit substrat le long d'au moins une direction (T), telle que ledit substrat (2) puisse être déplacé, au moins en partie, à travers un nuage (8) de matériau évaporé sous l'effet du laser afin de distribuer le dépôt dudit matériau sur une surface de dépôt dudit substrat de façon à faire croître un film dudit matériau sur ladite surface de dépôt.

17. Appareil selon la revendication 16, dans lequel ledit premier laser produit de la lumière comprenant une ou plusieurs longueurs d'onde dans la plage de 0,3 µm à 15 µm, de préférence dans la plage de 0,8 µm à 12 µm.

18. Appareil selon la revendication 16 ou 17, comprenant en outre une alimentation en gaz pour établir une atmosphère gazeuse, par exemple une atmosphère d'hydrogène, à l'intérieur de la chambre de dépôt.

19. Appareil selon la revendication 18, comprenant en outre des moyens pour décomposer le gaz formé par l'atmosphère gazeuse en plasma.

20. Appareil selon la revendication 19, dans lequel lesdits moyens pour décomposer le gaz en plasma comprennent deux électrodes et une alimentation en énergie réglable connectée à celles-ci.

21. Appareil selon la revendication 20, dans lequel une desdites électrodes, ou une troisième électrode connectée à ladite alimentation en énergie réglable, est configurée pour servir de support de substrat ou de support de cible.

22. Appareil selon l'une quelconque des revendications 16 à 21, dans lequel ledit matériau s'évaporant sous l'effet du laser dans lequel la cible est fabriquée est du silicium.

23. Appareil selon l'une quelconque des revendications 16 à 22, dans lequel ledit substrat est fabriqué dans un matériau résistant à la chaleur, tel que le verre.

24. Appareil selon l'une quelconque des revendications 16 à 23, dans lequel ladite cible de matériau s'évaporant sous l'effet du laser comprend un canal de fluide intérieur pour la circulation d'un fluide de réglage de la température.

25. Appareil selon l'une quelconque des revendications 16 à 24, comprenant en outre un dispositif de chauffage pour chauffer ledit substrat.

26. Appareil selon l'une quelconque des revendications 16 à 25, comprenant en outre un second laser pour une coopération avec ledit premier laser, dans lequel ledit second laser est actionné pour préchauffer au moins une surface spécifique partielle de ladite cible.

27. Appareil selon l'une quelconque des revendications 16 à 26, comprenant en outre au moins un capteur pour mesurer une température du substrat, une température de la cible ou la pression dans la chambre de dépôt.

28. Appareil selon la revendication 27, comprenant en outre un dispositif de réglage pour régler la température du substrat sur la base d'une entrée d'informations provenant d'un capteur de température du substrat, la température de la cible sur la base d'une entrée d'informations provenant d'un capteur de température de cible ou la pression dans la chambre de dépôt sur la base d'une entrée d'informations provenant d'un capteur de pression de la chambre de dépôt.
